# EUROPÄISCHE PATENTSCHRIFT

(11) **EP 3 192 341 B1**
(45) Veröffentlichungstag und Bekanntmachung des Hinweises auf die Patenterteilung: **13.11.2019**
(21) Anmeldenummer: 15762548.4
(22) Anmeldetag: 07.09.2015
(51) Int. Cl.: H05K 13/04, H02K 5/22

(54) **VERFAHREN ZUM MONTIEREN VON SMD-BAUTEILEN AN KONTAKTFEDERN BEI ELEKTROMOTOREN**
METHOD FOR MOUNTING SMD COMPONENTS ON CONTACT SPRINGS IN ELECTRIC MOTORS
PROCÉDÉ DE MONTAGE DE COMPOSANTS SMD AU NIVEAU DE RESSORTS DE CONTACT SUR DES MOTEURS ÉLECTRIQUES

(30) Priorität: 08.09.2014 DE 102014217924
(43) Veröffentlichungstag der Anmeldung: 19.07.2017
(73) Patentinhaber: CPT Group GmbH, 30165 Hannover (DE)
(72) Erfinder: WALLRAFEN, Werner, 65795 Hattersheim (DE); MURESAN, Daniel, 307220 Giroc (RO)
(86) Internationale Anmeldenummer: PCT/EP2015/070323
(87) Internationale Veröffentlichungsnummer: WO 2016/037955

(56) Entgegenhaltungen:
- EP-A1- 1 624 550
- WO-A1-2014/115244
- US-A- 6 045 653
- US-A1- 2005 239 331

## Beschreibung

Die vorliegende Erfindung betrifft ein Verfahren zum Montieren von SMD-Bauteilen an Kontaktfedern bei Elektromotoren.

SMD-Bauteile (SMD: Surface Mounted Device) zeichnen sich gegenüber bedrahteten elektronischen Bauteilen durch ihre kompakte Bauform und einfache Bestückung aus . Standardmäßig werden sie auf Leiterplatten oder Keramiksubstraten aufgebracht und mit Leiterbahnen oder Leiterplatten verlötet. Die Leiterbahnen müssen dann ihrerseits mit weiteren elektrischen Anschlüssen verbunden werden, insbesondere über Anschlusskabel oder -drähte.

Im vorliegenden Fall geht es um die Montage von derartigen SMD-Bauteilen an Kontaktfedern bei Elektromotoren. Solche SMD-Bauteile werden hierbei vorzugsweise in Hohlräumen angeordnet, die in entsprechenden Trägern für die SMD-Bauteile vorgesehen sind und in die Kontaktfedern von Seitenkontakten der Elektromotoren vorstehen. Da es sich bei den SMD-Bauteilen um sehr empfindliche Teile handelt, die beispielsweise aus Keramik bestehen, ist die Gefahr groß, dass bei der Montage dieser Bauteile durch die Berührung mit den Kontaktfedern aufgrund von Reibungs- oder Hafteffekten Beschädigungen an den SMD-Bauteilen verursacht werden.

Aus der US 2005/0239331 A1 ist eine Verbindungseinheit für einen Elektromotor bekannt. In dieser Veröffentlichung ist die Montage von SMD-Bauteilen an Kontaktfedern bei Elektromotoren offenbart. Maßnahmen, mit denen Beschädigungen an den SMD-Bauteilen bei der Montage dieser Bauteile durch die Berührung mit Kontaktfedern aufgrund von Reibungs- oder Hafteffekten vermieden werden können, sind in dieser Veröffentlichung jedoch nicht beschrieben.

Die EP 1 624 550 A1 beschreibt einen Chipträger, der eine Vielzahl von Federklemmen aufweist, die jeweils einer entsprechenden Seitenwand des Chipträgers zugeordnet sind und eine Innenfläche zum Kontakt mit einem seitlichen Anschluss des Chipträgers sowie eine Außenfläche zum Kontakt mit einem externen Anschluss des Chipträgers aufweisen. Die entsprechenden Federklemmen sorgen für die jeweiligen Verbindungen. Besondere Maßnahmen, um eine Beschädigung der Federklemmen bei der Montage der Bauteile zu verhindern, sind jedoch auch hier nicht beschrieben.

Der vorliegenden Erfindung liegt die Aufgabe zugrunde, ein Verfahren der eingangs genannten Art zur Verfügung zu stellen, das eine besonders schonende Behandlung der SMD-Bauteile bei deren Montage ermöglicht.

Diese Aufgabe wird erfindungsgemäß gemäß einer ersten Alternative durch ein Verfahren mit den folgenden Schritten in dieser Reihenfolge gelöst:
a. Ergreifen eines auf dem Boden eines Trägers des Elektromotors zu montierenden SMD-Bauteiles mit einem Greif- und Montagewerkzeug;
b. Bewegen des SMD-Bauteiles über die Montagestelle auf dem Träger;
c. Zurückdrücken einer in den Hohlraum vorstehenden Kontaktfeder mit einem Drücker;
d. Anordnen des SMD-Bauteiles auf dem Boden des Trägers;
e. Entfernen des Greif- und Montagewerkzeuges; und
f. Entfernen des Drückers.

Die erste Alternative des erfindungsgemäßen Verfahrens betrifft eine Verfahrensvariante, bei der ein SMD-Bauteil auf dem Boden eines Trägers des Elektromotors angeordnet wird, der bereits mit einer montierten Kontaktfeder versehen ist. Diese Kontaktfeder ist daher bereits vor der Montage des SMD-Bauteiles angeordnet worden. Beim Montieren des SMD-Bauteiles würde dieses daher ohne die erfindungsgemäßen Maßnahmen die Kontaktfeder kontaktieren (seitlich berühren), so dass es zu den vorstehend geschilderten Beschädigungen kommen könnte.

Erfindungsgemäß wird nunmehr die vorstehende Kontaktfeder mit einem Drücker zurückgedrückt, so dass das SMD-Bauteil völlig ohne Berührung oder mit verringerter Kraft bzw. verringertem Anpressdruck auf dem Boden des Trägers montiert werden kann. Vorzugsweise wird das SMD-Bauteil ohne jegliche mechanische Berührung mit der Kontaktfeder des Seitenkontaktes montiert. Nach der Montage des SMD-Bauteiles werden das Greif- und Montagewerkzeug für das SMD-Bauteil und der Drücker entfernt. Wenn der Drücker entfernt wird, bewegt sich die Kontaktfeder in ihren entspannten Zustand, in dem sie das SMD-Bauteil mit seitlichem Druck kontaktiert und den entsprechenden elektrischen Kontakt herstellt.

Bei einer zweiten Alternative des erfindungsgemäßen Verfahrens wird die Kontaktfeder erst dann montiert, nachdem das SMD-Bauteil auf dem Boden des Trägers angeordnet worden ist. Diese Alternative zeichnet sich daher durch die folgenden Verfahrensschritte in dieser Reihenfolge aus:
a. Ergreifen eines auf dem Boden eines Trägers des Elektromotors zu montierenden SMD-Bauteiles mit einem Greif- und Montagewerkzeug;
b. Anordnen des SMD-Bauteiles auf dem Boden des Trägers;
c. Pressen einer eine Kontaktfeder aufnehmenden Vorrichtung auf ein Bauteil des Elektromotors mit einem Presswerkzeug und gleichzeitiges Zurückhalten der Kontaktfeder mit einem Drücker;
d. Entfernen des Presswerkzeuges und des Drückers; und
e. Entfernen des Greif- und Montagewerkzeugs.

Bei dieser Verfahrensvariante wird daher die Kontaktfeder nach dem Montieren des SMD-Bauteiles auf dem Boden des Trägers montiert. Dies wird mit einem Presswerkzeug bewerkstelligt, das eine die Kontaktfeder aufnehmende Vorrichtung auf ein Bauteil, beispielsweise einen Bürstenhalter, des Elektromotors presst. Bei diesem Pressvorgang wird die Kontaktfeder mit einem Drücker zurückgehalten, so dass beim Montieren der Feder überhaupt keine mechanische Berührung mit dem bereits montierten SMD-Bauteil oder nur eine Berührung mit geringerer Kraft mit diesem auftritt. Optimalerweise findet überhaupt keine seitliche Berührung statt.

Nach dem Montieren der Kontaktfeder werden das Presswerkzeug und der Drücker entfernt, so dass sich die Kontaktfeder in ihren entspannten Zustand in Druckkontakt mit dem SMD-Bauteil bewegen kann. Es wird dann das Greif- und Montagewerkzeug entfernt. Dieses kann natürlich auch vor dem Entfernen des Presswerkzeuges und des Drückers entfernt werden.

Bei beiden Alternativen des erfindungsgemäßen Verfahrens entsteht daher beim Einbau des SMD-Bauteiles überhaupt keine Gleitberührung zwischen Bauteil und Kontaktfeder oder nur eine Berührung mit verringertem Anpressdruck, so dass die Gefahr von Beschädigungen des SMD-Bauteiles verringert ist.

Vorzugsweise wird das SMD-Bauteil in einem Hohlraum des Trägers, in den die Kontaktfeder versteht, angeordnet. Sowohl bei der 1. Alternative als auch bei der 2. Alternative des erfindungsgemäßen Verfahrens findet keine Berührung oder nur eine Berührung mit verringertem Anpassdruck mit der Kontaktfeder statt.

Bei der zweiten Alternative des erfindungsgemäßen Verfahrens wird vorzugsweise ein Presswerkzeug verwendet, an dem ein Drücker angeordnet ist. Bei dieser Variante bilden daher Presswerkzeug und Drücker eine Einheit, so dass ein einziges Bauteil und nicht zwei getrennte Vorrichtungen gehandhabt werden müssen. Beim Pressen der die Kontaktfeder aufweisenden Vorrichtung auf das zugehörige Bauteil des Elektromotors wird daher gleichzeitig die Kontaktfeder vom Drücker zurückgedrückt und zurückgehalten, so dass der erwähnte seitlich berührungsfreie Einbau möglich ist.

Des Weiteren wird bei der Montage des SMD-Bauteils dieses vorzugsweise bis zum Berühren von festen Leadframe-Kontakten bewegt. Bei einem solchen "Leadframe" handelt es sich beispielsweise um ein Stanzgitterteil, das an einem Träger fixiert ist. Der Leadframe dient zur Herstellung von elektrischen Verbindungen zu weiteren Funktionselementen der entsprechenden Baugruppe, bei denen es sich beispielsweise um weitere elektronische Bauteile oder elektromechanische Bestandteile der Baugruppe handeln kann. Jedenfalls wird das SMD-Bauteil hierbei so weit insbesondere in den Hohlraum bewegt, bis es mit den entsprechenden Leadframe-Kontakten in Berührung tritt.

Als Drücker findet bei dem erfindungsgemäßen Verfahren vorzugsweise ein Drückerstift Verwendung. Hierbei handelt es sich um ein schmales Werkzeug, das den Einbau des SMD-Bauteiles nicht behindert.

Das erfindungsgemäße Verfahren kann nacheinander für eine Vielzahl von SMD-Bauteilen bzw. für sämtliche SMD-Bauteile an einem Elektromotor durchgeführt werden. Bei einer bevorzugten Ausführungsform wird es gleichzeitig mit einer Vielzahl von zu montierenden SMD-Bauteilen durchgeführt. Hierbei findet daher ein einziger Vorgang mit den vorstehend aufgeführten einzelnen Verfahrensschritten statt.

Die Erfindung wird nachfolgend anhand eines Ausführungsbeispiels in Verbindung mit der Zeichnung im Einzelnen erläutert. Es zeigen:
- Figur 1: eine schematische Darstellung der Montage eines SMD-Bauteiles gemäß einer ersten Ausführungsform der Erfindung; und
- Figur 2: eine schematische Darstellung der Montage eines SMD-Bauteiles gemäß einer zweiten Ausführungsform der vorliegenden Erfindung.

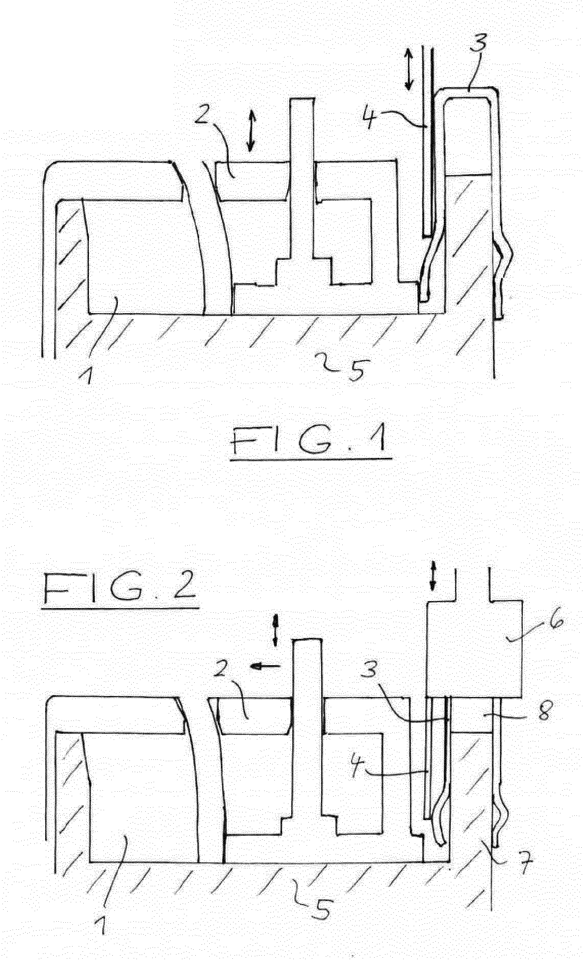

Figur 1 zeigt schematisch als Träger 5 einen Bürstenhalter aus Kunststoff eines Elektromotors, das einen nach oben offenen Hohlraum 1 aufweist, in den ein SMD-Bauteil 2 montiert werden soll. In den Hohlraum 1 ragt eine bereits am Träger 5 montierte Kontaktfeder 3, über die ein elektrischer Druckkontakt mit dem einzubauenden SMD-Bauteil 2 hergestellt werden soll. Das SMD-Bauteil 2 wird mit einem Greif- und Montagewerkzeug ergriffen und über dem Hohlraum 1 angeordnet. Mit einem als Drücker 4 ausgebildeten Stift wird die bereits vorher eingebaute Kontaktfeder 3 so weit zurückgedrückt, dass beim Einsetzen des SMD-Bauteiles 2 in den Hohlraum 1 kein Reib- bzw. Gleitkontakt mit der Kontaktfeder 3 auftritt. In Figur 1 ist der Drücker 4 in einer Stellung kurz vor dem Zurückdrücken der Kontaktfeder 3 gezeigt.

Nachdem das SMD-Bauteil 2 seine Endposition erreicht hat, werden das Greif- und Montagewerkzeug (nicht gezeigt) und der Drücker 4 wieder entfernt. Die Kontaktfeder 3 bewegt sich daher in die in Figur 1 dargestellt entspannte Stellung, in der sie das eingebaute SMD-Bauteil 2 druckkontaktiert.

Bei der schematisch in Figur 2 dargestellten Verfahrensvariante wird zuerst das SMD-Bauteil 2 im Hohlraum 1 des Trägers 5 angeordnet, wonach die Kontaktfeder 3 montiert wird. Hierbei wird das SMD-Bauteil 2 ebenfalls mit einem Greif- und Montagewerkzeug in den Hohlraum 1 hineinbewegt und dann in der Figur horizontal nach links bewegt, bis das SMD-Bauteil 2 die festen Leadframe-Kontakte (nicht gezeigt) berührt. Es wird dann eine die Kontaktfeder 3 aufnehmende Vorrichtung 8 (nur schematisch dargestellt) mit einem Presswerkzeug 6 auf den Abschnitt 7 des Bürstenhalters des Motors gepresst. Bei diesem Vorgang wird gleichzeitig mit einem am Presswerkzeug 6 angeordneten Drücker 4 in Form eines Stiftes die Kontaktfeder 3 zurückgedrückt und zurückgehalten, so dass beim Einbau der Feder kein Reib- bzw. Gleitkontakt mit dem bereits vorher eingebauten SMD-Bauteil 2 auftritt. Beim Entfernen des Presswerkzeuges 6 wird gleichzeitig der Drücker 4 mit nach oben bewegt, so dass die Kontaktfeder 3 ihre spannungsfreie Endstellung einnehmen kann, in der sie das eingebaute SMD-Bauteil 2 druckkontaktiert.

Bei beiden Verfahrensvarianten findet daher eine schonende Behandlung des SMD-Bauteiles 2 während des Einbaus statt.

## Patentansprüche

1. Verfahren zum Montieren von SMD-Bauteilen (2) an Kontaktfedern (3) bei Elektromotoren mit den folgenden Schritten in dieser Reihenfolge:
a. Ergreifen eines auf dem Boden eines Trägers (5) des Elektromotors zu montierenden SMD-Bauteiles (2) mit einem Greif- und Montagewerkzeug;
b. Bewegen des SMD-Bauteiles (2) über die Montagestelle auf dem Träger (5);
c. Zurückdrücken einer vorstehenden Kontaktfeder (3) mit einem Drücker (4);
d. Anordnen des SMD-Bauteiles (2) auf dem Boden des Trägers (5);
e. Entfernen des Greif- und Montagewerkzeuges; und
f. Entfernen des Drückers (4).

2. Verfahren zum Montieren von SMD-Bauteilen (2)an Kontaktfedern bei Elektromotoren mit den folgenden Schritten in dieser Reihenfolge:
a. Ergreifen eines auf dem Boden eines Trägers (5) des Elektromotors zu montierenden SMD-Bauteiles (2) mit einem Greif- und Montagewerkzeug;
b. Anordnen des SMD-Bauteiles (2) auf dem Boden des Trägers (5);
c. Pressen einer eine Kontaktfeder (3) aufnehmenden Vorrichtung (8) auf ein Bauteil des Elektromotors mit einem Presswerkzeug (6) und gleichzeitiges Zurückhalten der Kontaktfeder (3) mit einem Drücker (4) ;
d. Entfernen des Presswerkzeuges (6) und des Drückers (4); und
e. Entfernen des Greif- und Montagewerkzeugs.

3. Verfahren nach Anspruch 1 oder 2, **dadurch gekennzeichnet, dass** das SMD-Bauteil (2) in einem Hohlraum (1) des Trägers (5), in den die Kontaktfeder (3) vorsteht, angeordnet wird.

4. Verfahren nach Anspruch 2 oder 3, **dadurch gekennzeichnet, dass** ein Presswerkzeug (6) verwendet wird, an dem ein Drücker (4) angeordnet ist.

5. Verfahren nach einem der vorstehenden Ansprüche, **dadurch gekennzeichnet, dass** das SMD-Bauteil (2) bis zum Berühren von festen Leadframe-Kontakten auf seine Montagestelle bewegt wird.

6. Verfahren nach einem der vorangehenden Ansprüche, **dadurch gekennzeichnet, dass** als Drücker (4) ein Drückerstift verwendet wird.

7. Verfahren nach einem der vorangehenden Ansprüche, **dadurch gekennzeichnet, dass** es gleichzeitig mit einer Vielzahl von zu montierenden SMD-Bauteilen (2) durchgeführt wird.

## Claims

1. Method for mounting SMD components (2) on contact springs (3) in electromotors having the following steps in this order:
a. gripping an SMD component (2) to be mounted on the base of a support (5) of the electromotor using a gripping and mounting tool;
b. moving the SMD component (2) over the mounting point on the support (5);
c. pushing back a projecting contact spring (3) using a pusher (4) ;
d. arranging the SMD component (2) on the base of the support (5) ;
e. removing the gripping and mounting tool; and
f. removing the pusher (4).

2. Method for mounting SMD components (2) on contact springs in electromotors having the following steps in this order:
a. gripping an SMD component (2) to be mounted on the base of a support (5) of the electromotor using a gripping and mounting tool;
b. arranging the SMD component (2) on the base of the support (5) ;
c. pressing a device (8) holding a contact spring (3) onto a component of the electromotor using a pressing tool (6) and simultaneously holding back the contact spring (3) using a pusher (4);
d. removing the pressing tool (6) and the pusher (4); and
e. removing the gripping and mounting tool.

3. Method according to Claim 1 or 2, **characterized in that** the SMD component (2) is arranged in a cavity (1) of the support (5) into which the contact spring (3) projects.

4. Method according to Claim 2 or 3, **characterized in that** a pressing tool (6) is used on which a pusher (4) is arranged.

5. Method according to one of the preceding claims, **characterized in that** the SMD component (2) is moved onto its mounting point until it touches fixed lead frame contacts.

6. Method according to one of the preceding claims, **characterized in that** a pusher pin is used as a pusher (4).

7. Method according to one of the preceding claims, **characterized in that** it is performed simultaneously with multiple SMD components (2) to be mounted.

## Revendications

1. Procédé de montage de composants CMS (2) sur des ressorts de contact (3) dans des moteurs électriques, le procédé comprenant les étapes suivantes dans cet ordre :
a. prendre un composant CMS (2) à monter sur le fond d'un support (5) du moteur électrique avec un outil de préhension et de montage ;
b. déplacer le composant CMS (2) au-dessus de l'emplacement de montage sur le support (5) ;
c. repousser un ressort de contact saillant (3) avec un poussoir (4) ;
d. disposer le composant CMS (2) sur le fond du support (5) ;
e. retirer l'outil de préhension et de montage ; et
f. retirer du poussoir (4).

2. Procédé de montage de composants CMS (2) sur des ressorts de contact dans des moteurs électriques, le procédé comprenant les étapes suivantes dans cet ordre :
a. prendre un composant CMS (2) à monter sur le fond d'un support (5) du moteur électrique avec un outil de préhension et de montage ;
b. disposer le composant CMS (2) sur le fond du support (5) ;
C. presser un dispositif (8) de réception de ressort de contact (3) sur un composant du moteur électrique avec un outil de pressage (6) et maintenir en même temps le ressort de contact (3) avec un poussoir (4) ;
d. retirer l'outil de pressage (6) et le poussoir (4) ; et
e. enlever l'outil de préhension et de montage.

3. Procédé selon la revendication 1 ou 2, **caractérisé en ce que** le composant CMS (2) est disposé dans une cavité (1) du support (5) dans laquelle le ressort de contact (3) fait saillie.

4. Procédé selon la revendication 2 ou 3, **caractérisé en ce qu'**un outil de pressage (6) est utilisé sur lequel est disposé un poussoir (4).

5. Procédé selon l'une des revendications précédentes, **caractérisé en ce que** le composant CMS (2) est déplacé de manière à venir en contact avec des contacts fixes de la grille de connexion à son emplacement de montage.

6. Procédé selon l'une des revendications précédentes, **caractérisé en ce qu'**un doigt de poussoir est utilisé comme poussoir (4).

7. Procédé selon l'une des revendications précédentes, **caractérisé en ce qu'**il est mis en œuvre en même temps qu'une pluralité de composants CMS (2) à monter.
